# EUROPÄISCHE PATENTSCHRIFT

(11) **EP 0 896 898 B1**
(45) Veröffentlichungstag und Bekanntmachung des Hinweises auf die Patenterteilung: **19.04.2006**
(21) Anmeldenummer: 98113337.4
(22) Anmeldetag: 17.07.1998
(51) Int. Cl.: B60Q 1/26

(54) **Träger, vorzugsweise für Heckleuchten von Kraftfahrzeugen**
Supporting means, especially for vehicle rear lights
Support, de préferénce pour les feux arrière d'un véhicule

(30) Priorität: 12.08.1997 DE 19734748
(43) Veröffentlichungstag der Anmeldung: 17.02.1999
(73) Patentinhaber: Schefenacker Vision Systems Germany GmbH, 73730 Esslingen (DE)
(72) Erfinder: Kugler, Achim, 71540 Murrhardt (DE); Weber, Christine, 73728 Esslingen (DE)
(74) Vertreter: Jackisch-Kohl, Anna-Katharina

(56) Entgegenhaltungen:
- EP-A- 0 531 185
- EP-A- 0 596 782
- US-A- 4 774 394
- US-A- 4 906 812
- US-A- 5 404 282
- US-A- 5 519 596
- WHITEHEAD D G ET AL: "Soldering with light!" ASSEMBLY AUTOMATION, 1995, UK, Bd. 15, Nr. 2, Seiten 17-19, XP002085042 ISSN 0144-5154
- PATENT ABSTRACTS OF JAPAN Bd. 95, Nr. 01, & JP 06 296073 A
- PATENT ABSTRACTS OF JAPAN Bd. 007, Nr. 211 (M-243), & JP 58 107291 A

## Beschreibung

Die Erfindung betrifft einen Träger, vorzugsweise für Heckleuchten von Kraftfahrzeugen, nach dem Oberbegriff des Anspruches 1 bzw. 3.

Bekannte Träger sind als Leiterbahnen ausgebildet, die in Kraftfahrzeugheckleuchten hinter einer Lichtscheibe angeordnet und auf denen Glühlampen in Fassungen gehalten sind.

Es sind auch Träger bekannt, auf denen LEDs durch Löten befestigt sind. Beim Löten treten jedoch Temperaturprobleme auf. Die LEDs können leicht vorgeschädigt werden, weil die Temperatur beim Löten einen vorgegebenen Grenzwert überschreiten kann. Hierdurch kann die Lebensdauer der LEDs herabgesetzt werden. Auch sind wegen des Lötvorganges bei dreidimensionalen Bauteilen spezielle teure hochtemperaturbeständige Kunststoffe für den Träger erforderlich.

Es ist ferner bekannt, zur Vermeidung solcher Temperaturschäden die LEDs in einer sogenannten Snap-Technologie, einem mechanischen Fügeverfahren, auf dem Träger zu befestigen. Dies hat jedoch den Nachteil, daß für ein solches Verfahren nur LEDs mit einer bestimmten Größe und Form verwendet werden können. Um die LEDs beim Fügevorgang nicht zu beschädigen, müssen sie eine Mindestgröße und eine spezielle Bauform aufweisen. Die LEDs nehmen daher relativ viel Platz in Anspruch. Außerdem sind für die Montage der LEDs spezielle, aufwendige und teure Werkzeuge notwendig.

Es sind gattungsgemäße Träger bekannt (US 5 519 596), auf denen LEDs mit L-förmigen Anschlußteilen befestigt sind. Die L-förmigen Anschlußteile ragen durch Öffnungen im Träger und sind an dessen Rückseite festgeschweißt, so daß die Schweißstellen und die LEDs auf verschiedenen Seiten des Trägers liegen.

Es ist ferner bekannt (US 4 906 812), mikroelektronische Bauteile durch Laserschweißen miteinander zu verbinden. Hierfür wird ein Werkzeug eingesetzt, mit dem die miteinander zu verbindenden Werkstücke zusammengepreßt werden. Gleichzeitig wird der Laserstrahl auf den Bereich der Werkstücke gerichtet, an dem sie miteinander verbunden werden sollen.

Der Erfindung liegt die Aufgabe zugrunde, den gattungsgemäßen Träger so auszubilden, daß die LEDs auf einfache kostengünstige Weise und unter Vermeidung eventueller Vorschädigung auf dem Träger befestigt werden können.

Diese Aufgabe wird beim gattungsgemäßen Träger erfindungsgemäß mit den kennzeichnenden Merkmalen des Anspruches 1 bzw. 3 gelöst.

Beim erfindungsgemäßen Träger nach Anspruch 1 werden die wärmeempfindlichen LEDs durch Laserschweißen befestigt. Hierzu werden Hochleistungslaser verwendet, die sich durch kurze Pulsdauer, hohe Pulsfolge und eine hohe Leistung auszeichnen. Dadurch können die LEDs in kürzester Zeit und ohne daß die Gefahr einer Beschädigung der LEDs besteht, befestigt werden. Durch das Laserschweißen wird eine übermäßige Hitzeeinwirkung auf das Trägermaterial und die LEDs vermieden. Die LEDs können durch das Laserschweißen zuverlässig und sicher auf den Trägern befestigt werden, so daß sie einen sicheren Halt haben. Da die Laserschweißstelle und die LEDs auf der gleichen Seite des Trägers liegen, ist eine einfache Montage der LEDs auf dem Träger gewährleistet. Als elektronische Bauteile können auch kleine Legs verwendet werden, da zur Montage keine spezielle Bauform der LEDs erforderlich ist. Der Träger kann aus weniger hochtemperaturbeständigem und damit kostengünstigerem Kunststoff bestehen. Auch die Werkstoffpaarung der verwendeten Materialien ist weniger kritisch als bei herkömmlichen Leiterplatten, bei denen die elektronischen Bauteile durch Löten auf dem Träger befestigt werden. Dies wirkt sich ebenfalls günstig auf die Herstellungskosten des erfindungsgemäßen Trägers aus. Der Laserschweißvorgang läßt sich mit Robotern einfach und in kürzester Zeit durchführen.

Beim Träger gemäß Anspruch 3 können die LEDs mit ihren geraden Anschlußteilen einfach in die Öffnungen des Trägers gesteckt werden. Die freien Enden der Anschlußteile werden durch die Laserschweißnaht mit den Leiterbahnen verbunden.

Weitere Merkmale der Erfindung ergeben sich aus den weiteren Ansprüchen, der Beschreibung und den Zeichnungen.

Die Erfindung wird nachstehend anhand zweier in den Zeichnungen dargestellter Ausführungsbeispiele näher beschrieben. Es zeigt:
- Fig. 1: einen Schnitt durch eine Kraftfahrzeugheckleuchte mit einem erfindungsgemäßen Träger, auf dem mehrere LED's befestigt sind,
- Fig. 2: die Einzelheit II in Fig. 1, bei der eine der LED's am Träger verschweißt ist, in vergrößerter Darstellung,
- Fig. 3: einen Teil eines erfindungsgemäßen Trägers, an dem eine LED verschweißt ist.

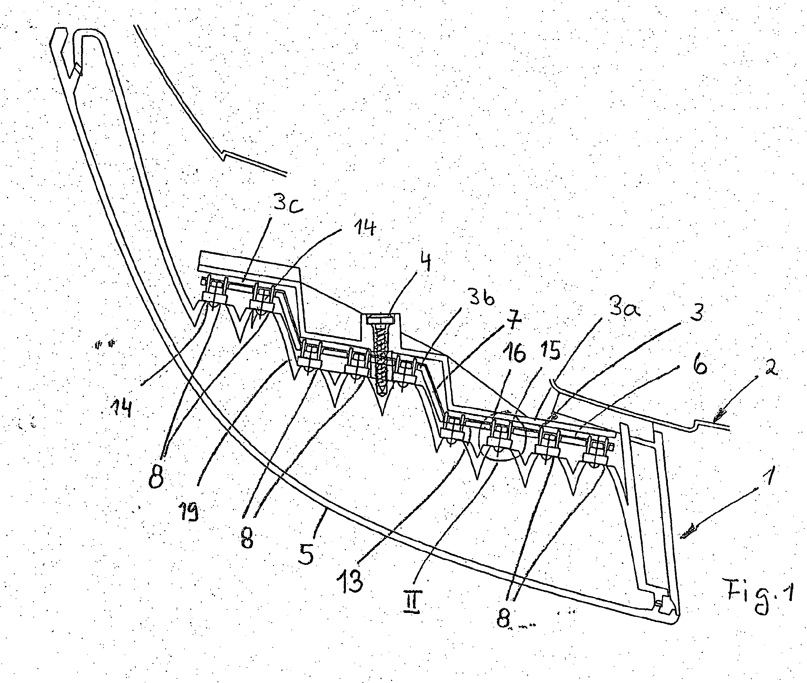

In Fig. 1 ist eine Heckleuchte 1 eines Kraftfahrzeuges dargestellt, die an einer andeutungsweise dargestellten Karosserie 2 des Kraftfahrzeuges befestigt ist. Die Heckleuchte 1 hat einen Träger 3, der an der Karosserie 2 mit Schrauben 4 befestigt ist. Auf dem Träger 3 sind Leiterbahnen 7 vorgesehen, an die mehrere als LED's, 8 ausgebildete elektronische Bauteile angeschlossen sind. Der Träger 3 liegt mit Abstand hinter einer Lichtscheibe 5, die die Heckleuchte 1 abschließt. Der Träger 3 besteht vorzugsweise aus hochtemperaturfestem thermoplastischem Material, auf dem die aus Metall bestehenden Leiterbahnen 7 aufgebracht sind. Der Träger 3 kann aber auch durch Umspritzen der Leiterbahnen mit Kunststoff, vorzugsweise Polycarbonat, hergestellt sein. Vorteilhaft ist der Schaltungsträger 3 ein spritzgegossenes Formteil, das mit einer integrieten Leiterbildstruktur versehen ist. Der Träger 3 ist im dargestellten Ausführungsbeispiel ein dreidimensionales Bauteil, das drei unterschiedlich breite Stufen 3a, 3b und 3c aufweist, auf denen jeweils mehrere LED's 8 befestigt sind. Auf der ersten, breitesten Stufe 3a sind vier in Reihe nebeneinander liegende LED's 8 vorgesehen, während auf der mittleren Stufe 3b nur drei Reihen von LED's angeordnet sind. Die Stufe 3c ist am schmalsten und trägt nur zwei Reihen von LED's. Selbstverständlich kann die Anordnung der Stufen und der LED's beliebig anders gewählt sein. Anstelle einer stufigen Ausbildung kann der Träger 3 z.B. auch gekrümmt ausgebildet sein. Der Träger 3 kann aber auch nur zweidimensional als Platte ausgebildet sein.

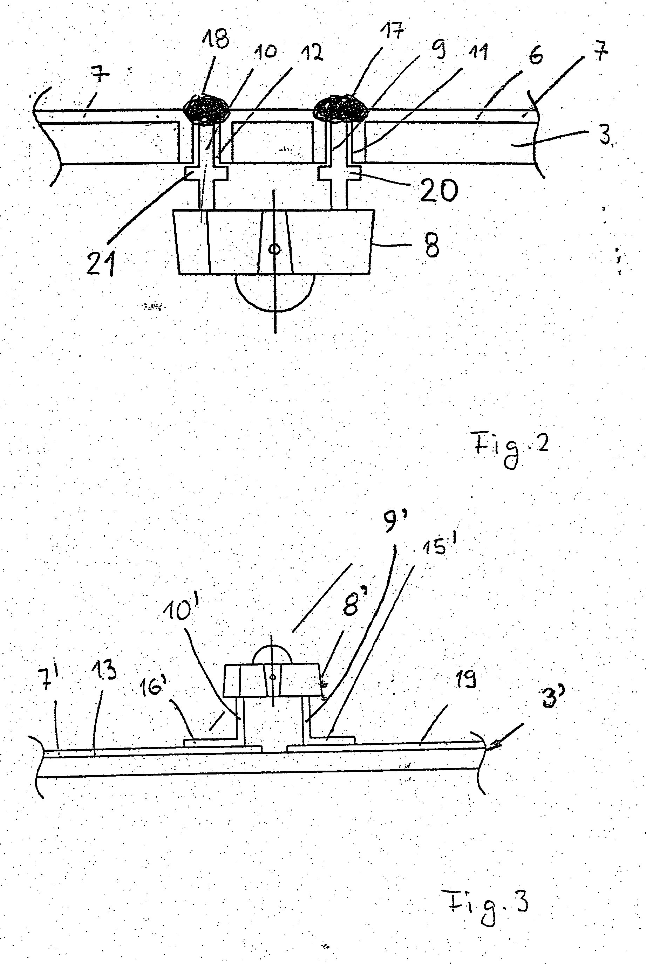

Jede LED 8 ragt mit ihren zwei Füßen 9, 10 (Fig. 2) durch Stecköffnungen 11, 12 des Trägers 3. Die Füße 9, 10 werden so weit durch die Öffnungen 11, 12 gesteckt, bis sie mit auf ihnen sitzenden Anschlägen 20, 21 am Träger 3 zur Anlage kommen und ihre freien Enden 15, 16 (Fig. 1) über die Rückseite 6 des Trägers 3 ragen. Die Enden 15, 16 der Füße 9, 10 der LED's 8 werden auf der Rückseite 6 des Trägers 3 durch Laserschweißen mit den Leiterbahnen 7 verschweißt. Fig. 2 zeigt die entstehenden Schweißstellen 17, 18. Hier- zu werden Hochleistungslaser verwendet, die sich durch eine kurze Pulsdauer, eine hohe Pulsfolge und eine hohe Leistung auszeichnen. Dadurch sind die LED's während des Schweißvorganges nur einer geringen Wärmebeanspruchung ausgesetzt, so daß eine Vorschädigung der LED's ausgeschlossen ist. Durch Laserschweißen können die LED's einfach und in kürzester Zeit montiert werden. Mit diesem Verfahren kann eine sehr sichere Verschweißung der LED's 8 am Träger 3 erreicht werden, wobei auch der Träger nur einer sehr kurzen Wärmeeinwirkung ausgesetzt ist. Außerdem können zur Herstellung des Trägers wegen der nur geringen Wärmebelastung weniger hochtemperaturbeständige und damit kostengünstigere Kunststoffe eingesetzt werden. Schließlich ist auch die Werkstoffpaarung weniger kritisch als bei herkömmlichen Lötverfahren. Bei dem beschriebenen Hochleistungslaserschweißen können die LED's relativ klein ausgebildet sein, da zu ihrer Montage keine spezielle Bauform erforderlich ist. Zur Montage der LED's 8 kann ein Schweißroboter eingesetzt werden, mit dem die LED's schnell und zuverlässig am Träger 3 angeschweißt werden können. Die LED's werden vorteilhaft automatisiert in den Träger 3 gesteckt und in der beschriebenen Weise von hinten verschweißt.

Fig. 3 zeigt eine weitere Ausführungsform eines Trägers 3, bei dem die LED's 8' auf der Vorderseite 13 des Trägers 3' verschweißt sind. Der Träger 3' kann wie bei der zuvor beschriebenen Ausführungsform dreidimensionäl mit mehreren hintereinander liegenden Stufen, aber auch gekrümmt oder auch nur zweidimensional ausgebildet sein. Die LED's 8' haben die Füße 9', 10', die etwa in halber Länge rechtwinklig nach außen und in entgegengesetzte Richtung abgewinkelte Enden 15', 16' aufweisen. Zur Montage werden die LED's 8' mit ihren abgewinkelten Fußenden 15', 16' auf die entsprechenden Leiterbahnen 7' auf der Vorderseite 13 des Trägers 3' aufgesetzt und durch Laserschweißen an den Leiterbahnen angeschweißt. Hierzu wird wiederum ein Hochleistungslaser verwendet, mit dem die LED's 8' in kürzester Zeit und bei geringster Temperaturbelastung am Träger 3' sicher befestigt werden können. Die Montage der LED's 8' ist äußerst einfach und schnell durchzuführen, da ihre Füße 9', 10' lediglich auf die Leiterbahnen 7' aufgesetzt und nicht durch Öffnungen im Träger gesteckt werden müssen.

Die LED's 8, 8' ragen durch Öffnungen 14 (Fig. 1) in einem Reflektor 19, der der Lichtscheibe 5 mit Abstand gegenüberliegt. Der Schaltungsträger 3, 3' ist an der von der Lichtscheibe 5 abgewandten Seite des Reflektors 19 angeordnet und vorteilhaft zusammen mit ihm mit den Schrauben 4 gehalten.

## Patentansprüche

1. Träger, vorzugsweise für Heckleuchten von Kraftfahrzeugen, mit LEDs (8'), die mindestens einen L-förmig ausgebildeten Anschlußteil (9', 10') aufweisen, der mit einem rechtwinklig abgewinkelten Ende (15', 16') auf einer Leiterbahn (7') festgeschweißt ist,
**dadurch gekennzeichnet, daß** das abgewinkelte Ende (15', 16') des Anschlußteiles (9', 10') über eine Laserschweißstelle mit der Leiterbahn (7') verbunden ist, daß die LED (8') und die Schweißstelle auf der gleichen Seite des Trägers (3') liegen, und daß der Träger (3') aus Kunststoff besteht.

2. Träger nach Anspruch 1,
**dadurch gekennzeichnet, daß** die Laserschweißstelle auf der Vorderseite (13) des Trägers (3') liegt.

3. Träger, vorzugsweise für Heckleuchten von Kraftfahrzeugen, mit LEDs (8), die mindestens einen Anschlußteil (9, 10) aufweisen, der durch wenigstens eine Öffnung (11, 12) im Träger (3) ragt und dessen über den Träger (3) vorstehendes Ende (15, 16) an der von der LED (8) abgewandten Seite (6) des Trägers (3) mit Leiterbahnen (7) verschweißt ist, **dadurch gekennzeichnet, daß** der Anschlußteil (9, 10) so in die Öffnung (11, 12) ragt, daß die freien Enden (15, 16) durch eine Laserschweißnaht (17, 18) mit den Leiterbahnen verbunden sind, und daß der Träger (3) aus Kunststoff besteht.

4. Träger nach Anspruch 3,
**dadurch gekennzeichnet, daß** der Anschlußteil (9, 10) einen Anschlag (20, 21) aufweist, mit dem die LED (8) am Träger (3) zur Anlage kommt.

5. Träger nach einem der Ansprüche 1 bis 4,
**dadurch gekennzeichnet, daß** der Träger (3, 3') mit Abstand hinter einer Lichtscheibe (5) der Heckleuchte (1) liegt.

6. Träger nach einem der Ansprüche 1 bis 5,
**dadurch gekennzeichnet, daß** die LEDs (8, 8') durch Öffnungen (14) in einem Reflektor (19) ragen.

## Claims

1. A support, preferably for rear lights of motor vehicles, with LEDs (8') which have at least one L-shaped connecting part (9', 10'), the end (15', 16') of which is bent at right angles and fixedly welded to a conductive track (7'), **characterised in that** the bent end (15', 16') of the connecting part (9', 10') is connected to the conductive track (7') by means of a laser weld, **in that** the LED (8') and the weld lie on the same side of the support (3') and **in that** the support (3') is made of plastics.

2. A support according to claim 1, **characterised in that** the laser weld lies on the front side (13) of the support (3').

3. A support, preferably for rear lights of motor vehicles, with LEDs (8) which have at least one connecting part (9, 10) which projects through at least one opening (11, 12) in the support (3) and the end (15, 16) of which projects beyond the support (3) and is welded to conductive tracks (7) on the side (6) of the support (3) remote from the LED, **characterised in that** the connecting part (9, 10) projects into the opening (11, 12) so that the free ends (15, 16) are connected to the conductive tracks by means of a laser weld seam (17, 18) and **in that** the support (3) is made of plastics.

4. A support according to claim 3, **characterised in that** the connecting part (9, 10) has a stop (20, 21), by means of which the LED (8) comes to rest against the support (3).

5. A support according to any one of claims 1 to 4, **characterised in that** the support (3, 3') is arranged with spacing behind a light glass (5) of the rear light (1).

6. A support according to any one of claims 1 to 5, **characterised in that** the LEDs (8, 8') project through openings (14) in a reflector (19).

## Revendications

1. Support, de préférence pour feux de signalisation arrière d'un véhicule automobile, comportant des diodes électroluminescentes (8'), qui sont munies d'au moins un élément d'assemblage (9', 10') en forme de L, qui est fermement soudé sur une bande conductrice (7') par une extrémité coudée (15', 16') à angle droit, **caractérisé en ce que** l'extrémité coudée (15', 16') de l'élément d'assemblage (9', 10') est assemblée à la bande conductrice (7') par l'intermédiaire d'une zone de soudage au laser, **en ce que** la diode électroluminescente (8') et la zone de soudage sont disposées sur la même face du support (3'), et **en ce que** le support (3') est réalisé en matière plastique.

2. Support selon la revendication 1, **caractérisé en ce que** la zone de soudage au laser est située sur la face avant (13) du support (3').

3. Support, de préférence pour feux de signalisation arrière d'un véhicule automobile, comportant des diodes électroluminescentes (8), qui sont munies d'au moins un élément d'assemblage (9, 10), qui passe à travers au moins un orifice (11, 12) dans le support (3) et dont l'extrémité (15, 16) en saillie sur le support (3) est soudée à des bandes conductrices (7) sur la face (6) du support (3) opposée à la diode électroluminescente (8), **caractérisé en ce que** l'élément d'assemblage (9, 10) s'engage dans l'orifice (11, 12) de telle sorte que les extrémités libres (15, 16) sont assemblées aux bandes conductrices par un cordon de soudure au laser (17, 18), et **en ce que** le support (3) est en matière plastique.

4. Support selon la revendication 3, **caractérisé en ce que** l'élément d'assemblage (9, 10) comporte une butée (20, 21), avec laquelle la diode électroluminescente (8) vient en appui contre le support (3).

5. Support selon l'une quelconque des revendications 1 à 4, **caractérisé en ce que** le support (3, 3') est situé à distance derrière une plaque lumineuse (5) du feu de signalisation arrière (1).

6. Support selon l'une quelconque des revendications 1 à 5, **caractérisé en ce que** les diodes électroluminescentes (8, 8') s'engagent à travers des orifices (14) dans un réflecteur (19).
